# EUROPÄISCHE PATENTSCHRIFT

(11) **EP 1 595 288 B1**
(45) Veröffentlichungstag und Bekanntmachung des Hinweises auf die Patenterteilung: **25.12.2013**
(21) Anmeldenummer: 04710803.0
(22) Anmeldetag: 13.02.2004
(51) Int. Cl.: H01L 23/051, H01L 23/62

(54) **HALBLEITERMODUL**
SEMICONDUCTOR MODULE
MODULE A SEMI-CONDUCTEUR

(30) Priorität: 18.02.2003 DE 10306767
(43) Veröffentlichungstag der Anmeldung: 16.11.2005
(73) Patentinhaber: Infineon Technologies Bipolar GmbH & Co. KG, 59581 Warstein (DE)
(72) Erfinder: SCHOLZ, Detlef, 59494 Soest (DE); GERSTENKOEPER, Heinrich, 59581 Warstein (DE)
(74) Vertreter: Bauer Vorberg Kayser Patentanwälte
(86) Internationale Anmeldenummer: PCT/EP2004/001384
(87) Internationale Veröffentlichungsnummer: WO 2004/075290

(56) Entgegenhaltungen:
- EP-A- 0 415 059
- DE-A1- 1 413 915
- DE-A1- 19 828 417
- US-A- 3 581 160
- US-A- 4 099 201
- US-A- 4 150 394
- US-A- 4 399 452

## Beschreibung

Die Erfindung findet Anwendung in technischen Gebieten, bei denen Leistungshalbleiter zur Steuerung hoher Spannungen, typischerweise mehrerer Hundert oder Tausend Volt oder hoher Ströme, typischerweise mehrere Zehn oder Hundert Ampere eingesetzt werden. Dies ist beispielsweise auf dem Gebiet der Energieversorgung oder bei der Ansteuerung von leistungsfähigen elektrischen Maschinen, wie zum Beispiel Motorantrieben der Fall.

Die Erfindung bezieht sich auf ein Halbleitermodul mit einem Halbleiterelement und zwei Anschlusselektroden, zwischen denen das Halbleiterelement angeordnet und mit denen es elektrisch leitend kontaktiert ist, wobei das Halbleiterelement von einem wenigstens teilweise elektrisch isolierenden Gehäuse umgeben ist. Derartige Anordnungen sind zum Beispiel aus der DE 30 32 133 und der DE 26 52 348 bekannt, wobei dort zum Schutz vor Lichtbögen festkörpergefüllte Gehäuse zum Einsatz kommen.

Üblicherweise werden Schalteinrichtungen für hohe Spannungen oder hohe Stromstärken als mechanische Schalter ausgebildet, bei denen zwei Kontakte durch Bewegung wenigstens eines Kontaktes unter Erzeugung eines Funkens beziehungsweise Lichtbogens voneinander getrennt werden. Dies erfordert die Konstruktion und den Bau eines Schalterantriebes sowie Kraftspeicher, Verklinkungen und Steuerungen für den Antrieb und lichtbogenresistente Schaltkontakte.

Der konstruktive Aufwand für derartige Schalter lässt sich grundsätzlich durch die Verwendung von Halbleitern wesentlichen reduzieren. Halbleiter finden außerdem Anwendung bei Steuerungen, bei denen es nicht nur auf das Ein- und Ausschalten eines Stromes, sondern auf die Steuerung einer elektrischen Größe, die Gleichrichtung eines Wechselstroms oder ein sehr schnelles kontrolliertes Ein- und Aussschalten eines Stromes ankommt.

Jedoch ist die Verwendung von Leistungshalbleitern in hohen Leistungsbereichen anspruchsvoll wegen der begrenzten Spannungs- und Stromfestigkeit.

Eine hohe Belastbarkeit wird bekannter Weise durch die Verwendung von Druckkontaktbauformen in Scheibenzellenform (Presspack, Hockeypug) erreicht. Dies ist beispielsweise für Thyristoren und Dioden bekannt. Dabei ist ein Halbleiterelement jeweils in ein Gehäuse mit beidseitigen Anschlusskontakten eingebaut. Im Überlastfall bildet sich im Gehäuseinneren aufgrund der hohen Stromdichte, vom Halbleiterelement ausgehend ein zündfähiges Plasma, welches das Gehäuse zerstören und nach außen treten kann.

Auch für IGBT's (IGBT = Insulated Gate Bipolar Transistor) ist die Bauform in Druckkontakt-Gehäusen bekannt. Jedoch bedingen die MOS-Strukturen (MOS = Metal Oxide Semiconductor) auf der Chip-Oberseite von IGBT's technologische Nachteile. Die Herstellungsmethoden für IGBT's in Druckkontakt-Gehäusen sind somit aufwendig.

Der vorliegenden Erfindung liegt die Aufgabe zugrunde, ein Halbleitermodul mit hoher Belastbarkeit bei einfachem konstruktiven Aufbau und guter Montierbarkeit zu schaffen.

Die Aufgabe wird durch ein Halbleitermodul gemäß Patentanspruch 1 gelöst. Ausgestaltungen und Weiterbildungen des Erfindungsgedankens sind Gegenstand von Unteransprüchen.

Dabei ist vorgesehen, dass innerhalb des Gehäuses ein hochtemperaturfester Isolator vorgesehen ist, der wenigstens stellenweise zwischen einer Wand des Gehäuses und dem Halbleiterelement angeordnet ist, wobei zwischen der Innenwand des Isolators und zumindest Teilen der Anschlusselektroden des Halbleiterelements wenigstens ein innerer Hohlraum zur Ausbreitung eines Lichtbogens vorgesehen ist.

Entsteht durch eine Überlastung des Halbleitermoduls infolge einer zu hohen Stromdichte ein zündfähiges Plasma und bildet sich ein Lichtbogen zwischen den Anschlusselektroden aus, so verläuft der Lichtbogen entlang der Außenseite des Halbleiterelements und überbrückt dieses. Unter dem Begriff Lichtbogen sollen in diesem Zusammenhang auch schwächere Erscheinungsformen, wie jede Art von Entladung, insbesondere Koronaentladungen verstanden werden. Damit durch den Lichtbogen beziehungsweise seine mittelbaren und unmittelbaren Auswirkungen das Gehäuse nicht beschädigt wird, ist der hochtemperaturfeste Isolator vorgesehen, der das Gehäuse wenigstens teilweise vor den Auswirkungen des Lichtbogens schützt. Der Lichtbogen kann beispielsweise dadurch Schäden hervorrufen, dass sein Fußpunkt wandert und sich auf empfindlichen leitenden Materialien festsetzt, die nicht abbrandfest oder dünn ausgebildet sind. Außerdem bewirkt der Lichtbogen eine explosionsartige Aufheizung des in dem Gehäuse befindlichen Gases, so dass eine Druckwelle entsteht. Letztlich bewirkt der Lichtbogen auch eine starke Aufheizung des Gehäuseinneren, wodurch beispielsweise Lötstellen in Mitleidenschaft gezogen werden können.

Durch den inneren Hohlraum ist gewährleistet, dass ein etwa brennender Lichtbogen zwischen den Anschlusselektroden und der zylindrischen Innenwand des Isolators genügend Raum findet, um nicht nur zu brennen, sondern sich auch ausreichend zu bewegen, was zu einer Verwirbelung und Kühlung des Lichtbogens führt. Hierdurch ist erreicht, dass der Lichtbogen im Bereich der Anschlusselektroden und des Halbleiterelementes keine zu großen Schäden durch das lange Verharren auf einem bestimmten Fußpunkt hervorruft.

All diese Wirkungen werden durch einen hochtemperaturfesten Isolator wenigstens teilweise abgemildert, wenn dieser zwischen der Gehäuseinnenwand und dem Lichtbogen angeordnet ist und zwischen der Innenwand des Isolators und zumindest Teilen der Anschlusselektroden des Halbleiterelements wenigstens ein innerer Hohlraum zur Ausbreitung eines Lichtbogens vorgesehen ist.

Noch vorteilhafter ist es, wenn zwischen der Außenwand des Isolators und der Innenwand des Gehäuses wenigstens ein äußerer Hohlraum vorgesehen ist, wobei der Isolator thermomechanisch nachgibbar ausgeführt ist. Thermomechanisch nachgibbar bedeutet in diesem Zusammenhang, dass sich der Isolator bei einer Temperaturänderung sich mechanisch so ändert, dass er beispielsweise an Kontaktstellen durchlässig wird. Der Isolator (zum Beispiel Isolationsring) teilt das Gehäuse in zwei großvolumige Hohlräume (Kammern). In der inneren Kammer wird der konzentriert austretende Plasmastrahl verwirbelt. Hierdurch wird seine punktuell hochenergetische schädliche Form in eine großvolumige weniger schädliche Form transformiert. Gleichzeitig kann er sich das verwirbelte Plasma an den frei zugänglichen großflächigen Kontaktflächen abkühlen bevor dann der Isolationsring thermomechanisch nachgibt und die Plasmawolke in die außenliegende Kammer entlässt. Hier erfolgt dann durch Verwirbelung und Abkühlung eine letzte Unschädlichmachung.

Dabei kann wenigstens eine der Anschlusselektroden wenigstens teilweise in das Innere des Isolators hineinragt, insbesondere dann, wenn vorteilhafterweise die Innenwand des Isolators zylindrisch ausgebildet ist und/oder der Isolator das Halbleiterelement kreisringförmig umgibt.

Der Isolator besteht vorzugsweise aus Keramik, Glas und/oder Kunststoff. Darüber hinaus kann die Wandstärke des Isolators geringer sein als die Wandstärke des Gehäuses und/oder der innere Hohlraum ein geringeres Volumen aufweisen als der äußere Hohlraum.

Eine weitere vorteilhafte Ausgestaltung der Erfindung sieht vor, dass die Anschlusselektroden und/oder das Halbleiterelement eine Einrichtung zur Initiierung eines Lichtbogens tragen.

Durch eine derartige Einrichtung zur Initiierung eines Lichtbogens soll nicht etwa grundsätzlich ein Lichtbogen hervorgerufen werden, sondern es soll lediglich sichergestellt werden, dass bei einer Überlastung, wenn ohnehin ein Lichtbogen beziehungsweise eine Entladung entsteht oder ein Entstehen sehr wahrscheinlich ist, dieser an einer ganz bestimmten Stelle lokalisiert wird, beispielsweise durch eine scharfkantige Erhöhung an einer Anschlusselektrode, die eine Erhöhung der lokalen Feldstärke bewirkt und den Fußpunkt eines Lichtbogens an sich ziehen kann. Auf diese Weise ist sichergestellt, dass der Lichtbogen, wenn er brennt, dort positioniert werden kann, wo seine Wirkungen auf das Gehäuse durch geeignete Maßnahmen gemindert werden können.

Eine weitere vorteilhafte Ausgestaltung der Erfindung sieht vor, dass die Einrichtung zur Initiierung eines Lichtbogens in einem Bereich am Umfang des Halbleiterelementes angeordnet ist, der durch den Isolator gegenüber dem Gehäuse abgeschirmt ist.

Durch diese Maßnahme wird das Gehäuse bestmöglich im Falle des Auftretens eines Lichtbogens bei Überlastung vor dessen zerstörerischer Wirkung geschützt. Der hochtemperaturfeste Isolator kann beispielsweise aus einer geeigneten Keramik gebildet sein, die einerseits das Gehäuse effektiv abschirmt, andererseits selbst durch die Wirkungen des Lichtbogens nur wenig beschädigt wird.

Die Erfindung kann außerdem vorteilhaft dadurch ausgestaltet sein, dass der Isolator das Halbleiterelement kreisringförmig umgibt.

In diesem Fall ist das Gehäuse unabhängig von der Position eines etwa auftretenden Lichtbogens an dem Halbleiterelement im gesamten Bereich seiner zylindrischen Innenwand durch den hochtemperaturfesten Isolator effektiv geschützt.

Es kann außerdem vorgesehen werden, dass der Isolator die Form eines Hohlzylinders aufweist und in seinem Inneren das Halbleiterelement aufnimmt.

Durch die Form eines Hohlzylinders ist der Isolator besonders leicht und kostengünstig herstellbar und kann gut in den konstruktiven Aufbau des Halbleitermoduls integriert werden. Bei ausreichender Höhe des Hohlzylinders entsteht ein genügend großer Innenraum, um das Halbleiterelement sicher aufzunehmen und abzuschirmen.

Eine weitere vorteilhafte Ausgestaltung der Erfindung sieht vor, dass zwischen den Teilen der Anschlusselektroden, die in das Innere des Isolators hineinragen, und der zylindrischen Innenwand des Isolators der innere Hohlraum zur Ausbreitung eines Lichtbogens vorgesehen ist.

Durch diesen Aufbau ist es sichergestellt, dass der Lichtbogen, der seinen einen Fußpunkt auf einer der Anschlusselektroden ausbilden wird, auch im Bereich seines Fußpunktes noch von dem Isolator umgeben ist, so dass das Halbleiterelement und ggf. das Gehäuse vor der Einwirkung des Lichtbogens gut geschützt ist.

Es kann außerdem durch geeignete Vorrichtungen wie scharfkantige Stege auf den Anschlusselektroden oder Führungseinrichtungen an der inneren Wand des Isolators oder außen an dem Halbleiterelement ein Wandern der Fußpunkte und somit des Lichtbogens insgesamt mit dem Zwecke einer effektiven Kühlung bewirkt werden.

Weiterhin kann vorgesehen werden, dass der Innendurchmesser des Isolators abschnittsweise den äußeren Abmessungen des Halbleiterelements entspricht, so dass der Isolator das Halbleiterelement zentriert.

Wenn der Innendurchmesser des Isolators teilweise den äußeren Abmessungen des Halbleiterelements entspricht, so ist eine effektive Zentrierung und relative Positionierung von Halbleiterelement und Isolator möglich, die einerseits die Montage des Halbleitermoduls erleichtert und andererseits eine hohe mechanische Stabilität schafft.

Es kann auch vorgesehen sein, dass der Isolator wenigstens eine Schulter oder einen umlaufenden Steg aufweist, an der/dem wenigstens eine der Anschlusselektroden zentrierbar ist.

Durch dieses Merkmal wird die Montage des Halbleitermoduls weiter erleichtert und eine reproduzierbare Positionierung der einzelnen Bauteile des Moduls erreicht. Außerdem ist, wenn der Isolator an einer der Anschlusselektroden anliegt, hierdurch ein Abschluss des Lichtbogenraumes im Inneren des Isolators erreicht, der verhindert, dass der Lichtbogen an den Anschlusselektroden aus dem Inneren des Isolators heraus und in die Nähe der Gehäusewand gelangt. Die Anlage des Isolators an den Anschlusselektroden ist nicht gasdicht, so dass dort ein Gasaustausch erfolgen und auch der Überdruck durch einen etwa auftretenden Lichtbogen im Inneren des Isolators abgebaut werden kann. Lediglich der Lichtbogen selbst wird innerhalb des Isolators gehalten.

Zusätzlich kann vorgesehen sein, dass wenigstens eine der Anschlusselektroden einen zylindrischen Außenflansch aufweist, der ein zylindersymmetrisches Profil zur Zentrierung an dem Isolator aufweist sowie zentrisch innerhalb des Profils eine umlaufende Nut zur Vergrößerung des einem Lichtbogen zur Verfügung stehenden Raumes innerhalb des Isolators.

Durch diese Maßnahme steht dem Lichtbogen ein vergrößerter Raum zwischen den Anschlusselektroden und dem Isolator zur Verfügung, so dass eine effektivere Verwirbelung und Kühlung des Lichtbogens stattfinden kann, um eine Beschädigung des Halbleitermoduls zu verhindern.

Eine weitere vorteilhafte Ausgestaltung der Erfindung sieht vor, dass wenigstens eine der Anschlusselektroden einen zylindrischen Außenflansch aufweist, der ein zylindersymmetrisches Profil zur Zentrierung an dem Isolator aufweist sowie zentrisch innerhalb des Profils ein umlaufendes Profil zur Führung eines Lichtbogenfußpunktes.

Ein derartiges Profil zur Führung eines Lichtbogen-Fußpunktes bewirkt ein gezieltes Wandern des Fußpunktes des Lichtbogens an einer Anschlusselektrode mit dem Ziel einer effektiven Kühlung des Lichtbogens. Ein derartiges Profil ist beispielsweise ein im Querschnitt scharfkantig rechteckiger Steg, der spiralförmig an der Stirnseite der Anschlusselektrode umläuft.

Ein besonders einfacher und montagefreundlicher Aufbau eines erfindungsgemäßen Halbleitermoduls ergibt sich dadurch, dass eine einen zylindrischen Außenflansch aufweisende Anschlusselektrode am Umfang des Außenflansches ein mit diesem gasdicht verbundenes Anschlussblech zur gasdichten Verbindung mit einem zylindrischen Abschnitt des Gehäuses aufweist.

Das Anschlussblech kann beispielsweise bei der Herstellung einer Anschlusselektrode im Tiefziehverfahren mit angeformt sein. Zum Zusammenbau des Halbleitermoduls können dann die Anschlusselektroden, der Isolator und das Halbleiterelement geschichtet werden, wobei sie automatisch aneinander zentriert sind und zuletzt muss lediglich noch das Anschlussblech mit dem äußeren Gehäuse, das heißt einem Metallteil oder beispielsweise einem Keramikteil des äußeren Gehäuses gasdicht verlötet oder verklebt werden.

Die Erfindung wird nachfolgend anhand der in den Figuren der Zeichnung dargestellten Ausführungsbeispiele näher erläutert. Es zeigt:
- Figur 1: ein Halbleitermodul mit einem asymmetrischen Isolator und einem asymmetrischen Gehäuse,
- Figur 2: ein Halbleitermodul mit einem symmetrischen Isolator und einem asymmetrischen Gehäuse,
- Figur 3: ein Halbleitermodul mit einem symmetrischen Isolator und einem symmetrischen Gehäuse.

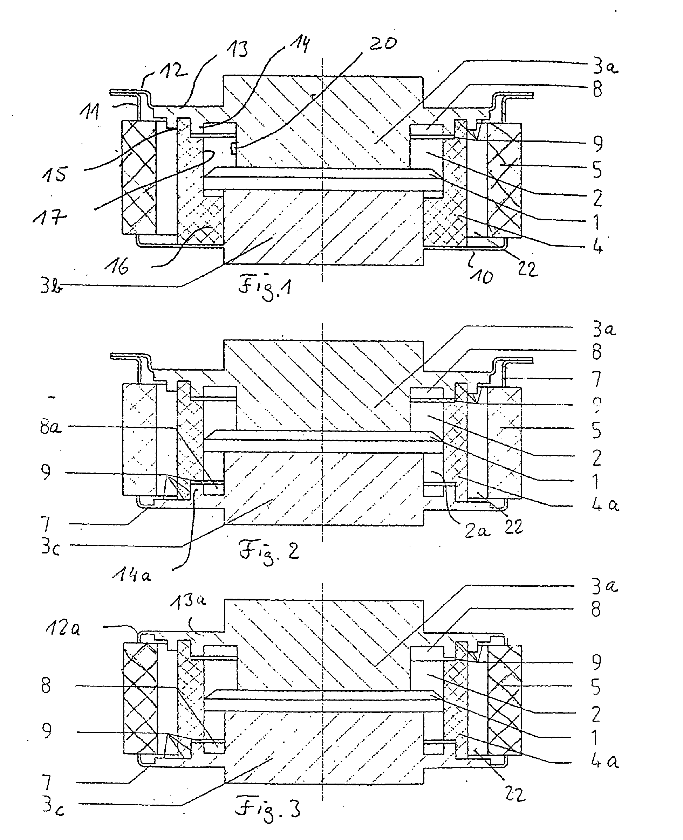

Die Figur 1 zeigt ein Halbleitermodul, bei dem ein zylindrisches, an seiner oberen umlaufenden Kante abgeschrägtes Halbleiterelement 1 vorgesehen ist, welches sich zwischen einer ersten Anschlusselektrode 3a und einer zweiten Anschlusselektrode 3b befindet und zwischen diesen durch Druck elektrisch kontaktiert ist. Die Anschlusselektroden 3a, 3b sind ebenfalls zylindrisch ausgebildet.

Außerdem ist ein Gehäuse vorgesehen mit einem Gehäuseisolator 5, der auf seiner Unterseite mit einem kreisrunden elektrisch leitenden Blech 10 verlötet ist, welches gasdicht mit der zweiten Anschlusselektrode 3b verbunden ist. Der Gehäuseisolator 5 ist an seiner anderen Stirnseite gasdicht mit einem Gehäuseblech 11 verbunden, welches im Zuge der Montage des Halbleitermoduls mit einem Anschlussblech 12 gasdicht verlötet, verschweißt oder verklebt wird. Das Anschlussblech 12 ist mit dem Außenflansch 13 der ersten Anschlusselektrode 3a verbunden.

Die ersten Anschlusselektrode 3a weist im Bereich ihres Außenflansches 13 einen umlaufenden Steg 14 auf, der an einer Schulter 15 des Isolators 4 zentriert ist.

Der Isolator 4 weist an seinem der Schulter 15 abgewandten stirnseitigen Ende einen Abschnitt 16 mit verringertem Innendurchmesser auf, in den die zweite Anschlusselektrode 3b passgenau hineinpasst.

Das Halbleiterelement 1 ist in seinem Durchmesser so gestaltet, dass es an der zylindrischen Innenwand 17 des Isolators 4 zentrierbar ist.

Zwischen der ersten Anschlusselektrode 3a und dem Isolator 4 ist erfindungsgemäß ein innerer Lichtbogenraum 2 (Hohlraum, Kammer) gebildet, in dem ein zwischen der zweiten Anschlusselektrode 3b und der ersten Anschlusselektrode 3a brennender Lichtbogen, der sich an der Außenseite des Halbleiterelementes 1 vorbei ausbildet, verwirbelt werden kann. Durch die Nut 8 in dem Außenflansch 13 der ersten Anschlusselektrode 3a wird dieser Lichtbogenraum zusätzlich vergrößert.

Des Weiteren ist zwischen der Außenwand des Isolators 4 und der Innenwand des Gehäuses 5 wenigstens eine Kammer 22 als äußerer Hohlraum vorgesehen, wobei der Isolator 4 thermomechanisch nachgibbar ausgeführt ist.

Dort, wo in dem mit dem Bezugszeichen 9 bezeichneten Bereich der Isolator 4 an die erste Anschlusselektrode 3a anstößt, ist ein sogenanntes Labyrinth ausgebildet, das heißt ein Bereich, der durchlässig für Gas ist, der jedoch den Lichtbogen in dem Lichtbogenraum 2 hält. Thermomechanisch nachgibbar bedeutet, dass sich der Isolator 4 bei einer Temperaturänderung sich mechanisch so ändert, dass er beispielsweise an dieser Kontaktstellen durch leichtes Öffnen der Kontaktstelle durchlässig wird.

Der Isolator 4 teilt das Gehäuse in zwei großvolumige Hohlräume (Kammern). In dem inneren Hohlraum (Lichtbogenraum 2) wird der konzentriert austretende Plasmastrahl verwirbelt. Hierdurch wird seine punktuell hochenergetische schädliche Form in eine großvolumige weniger schädliche Form transformiert. Gleichzeitig kann er sich das verwirbelte Plasma an den frei zugänglichen großflächigen Kontaktflächen abkühlen bevor dann der Isolator 4 thermomechanisch nachgibt und die Plasmawolke in den außenliegenden Hohlraum (Kammer 22) entlässt. Hier erfolgt dann durch Verwirbelung und Abkühlung eine letzte Unschädlichmachung.

Auf diese Weise wird das Gehäuse 5, 7, 10 vor den Einwirkungen des Lichtbogens geschützt.

Gemäß der Figur 2 ist bei einer gegenüber Figur 1 etwas veränderten Konstruktion des Halbleitermoduls der ersten Anschlusselektrode 3a eine zweite Anschlusselektrode 3c zugeordnet, die eine Nut 8a zur Vergrößerung des Lichtbogenraums 2a sowie einen Steg 14a zur Zentrierung des symmetrischen Isolators 4a aufweist. Bei dieser Ausgestaltung ist insgesamt der dem Lichtbogen zur Verfügung stehende Raum 2, 2a gegenüber dem Ausführungsbeispiel aus der Figur 1 vergrößert.

Das Ausführungsbeispiel aus der Figur 3 gleicht in Bezug auf die Vergrößerung des Lichtbogenraums und die symmetrische Ausgestaltung des Isolators 4a dem in der Figur 2 dargestellten Ausführungsbeispiel, wobei jedoch der Außenflansch 13a der ersten Anschlusselektrode 3a im Bereich des Anschlussbleches 12a direkt mit dem Isolator 5 des Gehäuses verbunden, beispielsweise verlötet ist. Zu diesem Zweck stehen Löttechniken zum gasdichten Verlöten von Keramik und Metallblechen aus dem Stand der Technik zur Verfügung.

Die hier dargestellten Konstruktionen haben gemeinsam, dass bis auf den Ausgleich von Fertigungstoleranzen durch die Maße der einzelnen Bauteile und ihre Abstimmung aufeinander die Montage nur in einer Art möglich und in einfacher Weise selbstzentrierend durchführbar ist. Fehler können somit bei der Montage weitgehend ausgeschlossen werden und die Montage ist im wesentlichen automatisch durchführbar.

Durch die Konstruktion wird eine hohe Belastbarkeit und eine lange Standzeit des Halbleitermoduls erreicht.

## Patentansprüche

1. Halbleitermodul mit einem Halbleiterelement (1) und zwei Anschlusselektroden (3a, 3b, 3c), zwischen denen das Halbleiterelement (1) angeordnet und mit denen es elektrisch leitend kontaktiert ist, wobei das Halbleiterelement (1) von einem wenigstens teilweise elektrisch isolierenden Gehäuse (5, 7, 11, 12) mit Wänden umgeben ist, wobei Innerhalb des Gehäuses (5, 7, 11, 12) ein als Wandung ausgebildeter hochtemperaturfester Isolator (4, 4a) wenigstens stellenweise zwischen einer Innenwand des Gehäuses (5, 7, 11, 12) und dem Halblelterelement (1) angeordnet ist, und zwischen der Innenwand des Isolators (4) und zumindest Teilen der Anschlusselektroden (3a, 3b, 3c) wenigstens ein innerer Hohlraum (2, 2a) zur Ausbreitung eines Lichtbogens vorgesehen ist, **dadurch gekennzeichnet, dass** in einem Bereich (9), in dem der Isolator an eine der Anschlusselektroden (3a) anstößt, ein gasdurchlässiges, den Lichtbogen im Hohlraum (2, 2a) zurückhaltendes Labyrinth ausgebildet ist.

2. Halbleitermodul nach Patentanspruch 1, bei dem zwischen der Außenwand des Isolators (4) und der Innenwand des Gehäuses (5, 7, 11, 12) wenigstens ein äußerer Hohlraum (22) vorgesehen Ist, wobei der Isolator (4) thermomechanisch nachgibbar ausgeführt ist.

3. Halbleitermodul nach Patentanspruch 1 oder 2, bei dem wenigstens eine der Anschlusselektroden (3a, 3b, 3c) wenigstens teilweise in das Innere des Isolators (4) hineinragt.

4. Halbleitermodul nach Patentanspruch 1, 2 oder 3, bei dem die Innenwand des Isolators (4) zylindrisch ausgebildet ist

5. Halbleitermodul nach Patentanspruch 4, bei dem der Isolator (4) das Halbleiterelement krelsringförmig umgibt..

6. Halbleltermodul nach einem der vorherigen Ansprüche, bei dem der Isolator (4) aus Keramik, Glas und/oder Kunststoff besteht.

7. Halbleitermodul nach einem der vorherigen Ansprüche, bei dem die Wandstärke des Isolators (4) geringer Ist als die Wandstärke des Gehäuses (5, 7, 11, 12).

8. Halbleitermodul nach einem der vorherigen Ansprüche, bei dem der innere Hohlraum (2, 2a) ein geringeres Volumen aufweist als der äußere Hohlraum (22)

9. Halbleitermodul nach einem der vorherigen Ansprüche, bei dem die Anschlusselektroden (3a, 3b, 3c) und/oder das Halbleiterelement (1) eine Einrichtung (20) zur Initiierung eines Lichtbogens tragen.

10. Halbleitermodul nach einem der vorherigen Ansprüche, bei dem die Einrichtung (20) zur Initiierung eines Lichtbogens in einem Bereich am Umfang des Halbleiterelementes (1) angeordnet ist, der durch den Isolator (4) gegenüber dem Gehäuse (5, 7, 11, 12) abgeschirmt ist.

11. Halbleitermodul nach einem der vorherigen Ansprüche, bei dem der Isolator (4) das Halbleiterelement kreisringförmig umgibt.

12. Halbleitermodul nach einem der vorherigen Ansprüche, bei dem der Innendurchmesser des Isolators (4) abschnittsweise den äußeren Abmessungen des Halbleiterelements (1) entspricht, so dass der Isolator (4) das Halbleiterelement (1) zentriert.

13. Halbleitermodul nach Anspruch 12, bei dem der Isolator (4) wenigstens eine Schulter oder einen umlaufenden Steg (15) aufweist, an der/dem wenigstens eine der Anschlusselektroden (3a, 3b, 3c), zentrierbar ist.

14. Halbleitermodul nach Anspruch 12 oder 13, bei dem wenigstens eine der Anschlusselektroden (3a, 3b, 3c) einen zylindrischen Außenflansch (13) aufweist, der ein zylindersymmetrisches Profil (14) zur Zentrierung an dem Isolator (4) aufweist sowie zentrisch Innerhalb des Profils eine umlaufende Nut (8) zur Vergrößerung des einem Lichtbogen zur Verfügung stehenden Raumes (2) Innerhalb des Isolators (4).

15. Halbleitermodul nach Anspruch 12 oder 13, bei dem wenigstens eine der Anschlusselektroden (3a, 3b, 3c) einen zylindrischen Außenflansch (13) aufweist, der ein zylindersymmetrisches Profil (14) zur Zentrierung an dem Isolator (4) aufweist sowie zentrisch innerhalb des Profils ein umlaufendes Profil zur Führung eines Lichtbogenfußpunktes.

16. Halbleitermodul nach einem der Ansprüche 14 oder 15, bei dem eine einen zylindrischen Außenflansch (13) aufweisende Anschlusselektrode (3a, 3b, 3c) am Umfang des Außenflansche ein mit diesem gasdicht verbundenes Anschlussblech (12) zur gasdichten Verbindung mit einem zylindrischen Abschnitt (5) des Gehäuses aufweist.

## Claims

1. A semiconductor module comprising a semiconductor element (1) and two terminal electrodes (3a, 3b, 3c) between which the semiconductor element (1) is arranged and to which it is electrically conductively connected, the semiconductor element (1) being surrounded by an at least partially electrically insulating housing (5, 7, 11, 12) having walls, wherein within the housing (5, 7, 11, 12), a high-temperature-resistant insulator (4, 4a) that is configured as a wall is arranged, at least in some areas, between an inner wall of the housing (5, 7, 11, 12) and the semiconductor element (1), and at least one inner cavity (2, 2a) is provided between the inner wall of the insulator (4) and at least parts of the terminal electrodes (3a, 3b, 3c) for the propagation of an arc, **characterised in that** a labyrinth that is permeable to gas and keeps the arc in the cavity (2, 2a) is formed in a region (9) where the insulator butts against one of the terminal electrodes (3a).

2. The semiconductor module according to claim 1, wherein at least one outer cavity (22) is provided between the outer wall of the insulator (4) and the inner wall of the (5, 7, 11, 12) housing, the insulator (4) being configured such that it is thermomechanically yielding.

3. The semiconductor module according to claim 1 or 2, wherein at least one of the terminal electrodes (3a, 3b, 3c) projects at least partially into the interior of the insulator (4).

4. The semiconductor module according to claim 1, 2 or 3, wherein the inner wall of the insulator (4) is configured to be cylindrical.

5. The semiconductor module according to claim 4, wherein the insulator (4) surrounds the semiconductor element in an annular manner.

6. The semiconductor module according to any one of the preceding claims, wherein the insulator (4) consists of ceramic, glass and/or plastic.

7. The semiconductor module according to any one of the preceding claims, wherein the wall thickness of the insulator (4) is less than the wall thickness of the housing (5, 7, 11, 12).

8. The semiconductor module according to any one of the preceding claims, wherein the inner cavity (2, 2a) has a smaller volume than the outer cavity (22).

9. The semiconductor module according to any one of the preceding claims, wherein the terminal electrodes (3a, 3b, 3c) and/or the semiconductor element (1) bear(s) a device (20) for initiating an arc.

10. The semiconductor module according to any one of the preceding claims, wherein the device (20) for initiating an arc is arranged in a region on the circumference of the semiconductor element (1), which region is shielded from the housing (5, 7, 11, 12) by the insulator (4).

11. The semiconductor module according to any one of the preceding claims, wherein the insulator (4) surrounds the semiconductor element in an annular manner.

12. The semiconductor module according to any one of the preceding claims, wherein the internal diameter of the insulator (4) in some sections corresponds to the external dimensions of the semiconductor element (1), so that the insulator (4) centres the semiconductor element (1).

13. The semiconductor module according to claim 12, wherein the insulator (4) has at least one shoulder or peripherally extending web (15), on which at least one of the terminal electrodes can be centred (3a, 3b, 3c).

14. The semiconductor module according to claim 12 or 13, wherein at least one of the terminal electrodes (3a, 3b, 3c) has a cylindrical outer flange (13), which has a cylinder-symmetrical profile (14) for centring on the insulator (4), and, centrally within the profile, a peripherally extending groove (8) for enlarging the space (2) available to an arc within the insulator (4).

15. The semiconductor module according to claim 12 or 13, wherein at least one of the terminal electrodes (3a, 3b, 3c) has a cylindrical outer flange (13), which has a cylinder-symmetrical profile (14) for centring on the insulator (4), and, centrally within the profile, a peripherally extending profile for guiding an arc root.

16. The semiconductor module according to claim 14 or 15, wherein a terminal electrode (3a, 3b, 3c) having a cylindrical outer flange (13) has, on the circumference of the outer flange, a terminal plate (12), which is connected to the latter in a gas-tight manner, for a gas-tight connection to a cylindrical section (5) of the housing.

## Revendications

1. Module à semi-conducteur comprenant un élément semi-conducteur (1) et deux électrodes de raccordement (3a, 3b, 3c) entre lesquelles est disposé ledit élément semi-conducteur (1) et avec lesquelles il est mis en contact électriquement conducteur, ledit élément semi-conducteur (1) étant entouré d'un boîtier (5, 7, 11, 12) à parois, qui est, au moins en partie, électriquement isolant, un isolateur (4, 4a) résistant à haute température qui est réalisé en tant que paroi étant disposé à l'intérieur dudit boîtier (5, 7, 11, 12), au moins par endroits, entre une paroi intérieure du boîtier (5, 7, 11, 12) et ledit élément semi-conducteur (1), et au moins un vide intérieur (2, 2a) destiné à la propagation d'un arc électrique étant prévu entre la paroi intérieure de l'isolateur (4) et au moins des parties desdites électrodes de raccordement (3a, 3b, 3c), **caractérisé par le fait qu'**un labyrinthe perméable au gaz et retenant ledit arc électrique dans le vide (2, 2a) est réalisé dans une zone (9) dans laquelle ledit isolateur est contigu à l'une des électrodes de raccordement (3a).

2. Module à semi-conducteur selon la revendication 1, dans lequel au moins un vide extérieur (22) est prévu entre la paroi extérieure de l'isolateur (4) et la paroi intérieure du boîtier (5, 7, 11, 12), ledit isolateur (4) étant réalisé de manière à pouvoir céder thermomécaniquement.

3. Module à semi-conducteur selon la revendication 1 ou 2, dans lequel l'une au moins des électrodes de raccordement (3a, 3b, 3c) se projette au moins en partie dans l'intérieur dudit isolateur (4).

4. Module à semi-conducteur selon la revendication 1, 2 ou 3, dans lequel la paroi intérieure de l'isolateur (4) est réalisée de façon cylindrique.

5. Module à semi-conducteur selon la revendication 4, dans lequel ledit isolateur (4) entoure en anneau de cercle ledit élément semi-conducteur.

6. Module à semi-conducteur selon l'une quelconque des revendications précédentes, dans lequel ledit isolateur (4) est réalisé en céramique, en verre et/ou en matière plastique.

7. Module à semi-conducteur selon l'une quelconque des revendications précédentes, dans lequel l'épaisseur de paroi de l'isolateur (4) est inférieure à l'épaisseur de paroi du boîtier (5, 7, 11, 12).

8. Module à semi-conducteur selon l'une quelconque des revendications précédentes, dans lequel ledit vide intérieur (2, 2a) présente un volume inférieur à celui du vide extérieur (22).

9. Module à semi-conducteur selon l'une quelconque des revendications précédentes, dans lequel lesdites électrodes de raccordement (3a, 3b, 3c) et/ou ledit élément semi-conducteur (1) portent un dispositif (20) d'initiation d'un arc électrique.

10. Module à semi-conducteur selon l'une quelconque des revendications précédentes, dans lequel ledit dispositif (20) d'initiation d'un arc électrique est disposé dans une zone sur la périphérie de l'élément semi-conducteur (1) qui est abritée par ledit isolateur (4) par rapport au boîtier (5, 7, 11, 12).

11. Module à semi-conducteur selon l'une quelconque des revendications précédentes, dans lequel ledit isolateur (4) entoure en anneau de cercle ledit élément semi-conducteur.

12. Module à semi-conducteur selon l'une quelconque des revendications précédentes, dans lequel le diamètre intérieur de l'isolateur (4) correspond par sections aux dimensions extérieures de l'élément semi-conducteur (1) de sorte que ledit isolateur (4) centre ledit élément semi-conducteur (1).

13. Module à semi-conducteur selon la revendication 12, dans lequel ledit isolateur (4) présente au moins un épaulement ou une nervure périphérique (15) sur lequel/laquelle peut être centrée l'une au moins des électrodes de raccordement (3a, 3b, 3c).

14. Module à semi-conducteur selon la revendication 12 ou 13, dans lequel l'une au moins des électrodes de raccordement (3a, 3b, 3c) comprend une bride extérieure cylindrique (13) qui présente un profilé à symétrie cylindrique (14) pour le centrage sur ledit isolateur (4) ainsi que, de manière centrée à l'intérieur du profilé, une rainure (8) périphérique pour agrandir l'espace (2) à l'intérieur de l'isolateur (4), qui est à la disposition d'un arc électrique.

15. Module à semi-conducteur selon la revendication 12 ou 13, dans lequel l'une au moins des électrodes de raccordement (3a, 3b, 3c) comprend une bride extérieure cylindrique (13) qui présente un profilé à symétrie cylindrique (14) pour le centrage sur ledit isolateur (4) ainsi que, de manière centrée à l'intérieur du profilé, un profilé périphérique pour guider un pied d'arc électrique.

16. Module à semi-conducteur selon l'une quelconque des revendications 14 ou 15, dans lequel une électrode de raccordement (3a, 3b, 3c) comprenant une bride extérieure cylindrique (13) présente, sur la périphérie de ladite bride extérieure, une tôle de raccordement (12) reliée d'une manière étanche au gaz à celle-ci et destinée à la liaison étanche au gaz avec une portion cylindrique (5) dudit boîtier.
